# EUROPEAN PATENT APPLICATION

(11) **EP 4 723 112 A1**
(43) Date of publication of application: **08.04.2026**
(21) Application number: 24204068.1
(22) Date of filing: 01.10.2024
(51) Int. Cl.: G11C 5/02, G11C 5/06, H10B 10/00, G11C 7/18, G11C 8/10, G11C 8/14

(54) **THREE-DIMENSIONAL INTEGRATED CIRCUIT**

(71) Applicant: Imec VZW, 3001 Leuven (BE); Katholieke Universiteit Leuven, KU Leuven R&D, 3000 Leuven (BE)
(72) Inventor: KUMARI, Bhawana, 3001 Heverlee (BE); WECKX, Pieter, 3380 Bunsbeek (BE); ABDI, Dawit Burusie, 3001 Leuven (BE)
(74) Representative: EIP

(57) **Abstract**

A three-dimensional integrated circuit, comprising a first tier, a second tier, vertically stacked above the first tier, and a memory circuit. The memory circuit comprises a bitcell array disposed in the first tier. The memory circuit also comprises a column peripheral circuit having at least an elongate first portion disposed in the second tier. The memory circuit also includes a row decoder being elongate and disposed in the second tier and extending in a direction parallel to the first portion of the column peripheral circuit.

## Description

### Technical Field

The present invention relates to a three-dimensional (3D) integrated circuit.

### Background

Conventionally, integrated memory circuits and integrated logic circuits are fabricated on separate semiconductor substrates. A memory chip and a logic chip may then be attached to a circuit board, where they are connected together using appropriate interconnects. With advances in semiconductor fabrication, there has been a move towards fabricating memory and logic circuits on the same substrate. This arrangement is referred to as a system-on-chip, or SoC. The benefits of SoCs over conventional discrete chips include compact size, improved power efficiency and improved performance, amongst other benefits.

There are various ways in which memory and logic circuits can be formed on the same substrate. For example, two-dimension (2D) partitioning involves placing the memory and logic circuits side-by-side in the same tier of the device. This has the advantage of being relatively straight-forward to implement, but it does mean that the interconnections between the memory and the logic circuits are relatively long, reducing the performance of the device.

3D integration involves placing the memory circuits and the logic circuits in different layers (or tiers) of the device. For example, S. M. Salahuddin et al., "Thermal Stress-Aware CMOS-SRAM Partitioning in Sequential 3-D Technology," in IEEE Transactions on Electron Devices, vol. 67, no. 11, pp. 4631-4635, Nov. 2020, doi: 10.1109/TED.2020.3023923, proposes using sequential integration to fabricate the logic circuit above a bitcell array of the memory circuit. This is referred to as array-under-CMOS (AuC).

Conventional 2D random-access memory (RAM) circuits include a bitcell array, together with a row decoder and column peripheral circuit. The row decoder and column peripheral circuit are arranged along the sides of the bitcell array and are typically orthogonal to each other. As such, they form an 'L' shape. In some cases, two bitcell arrays may be formed next to each other, and share some components of the row decoder. In these cases, the peripheral circuits form an inverted 'T' shape. The latter shape may be referred to as a butterfly arrangement, owing to the symmetry either side of the row decoder.

As noted in S. M. Salahuddin *et al.,* when performing 3D sequential integration, the memory bitcell array (and word and bit lines) may be formed in the RAM tier of the device. The CMOS logic circuit may be formed above the RAM tier in a CMOS tier. This allows separate optimisation of the RAM transistors and CMOS transistors. However, the peripheral circuits may be formed in the CMOS logic tier, as they also CMOS based.

While positioning the peripheral circuits in the CMOS tier provides benefits in terms of transistor optimisation, it does place design restrictions on the logic circuits, as they must be arranged around the peripheral circuits.

In view of the above, there is a requirement for improvements in the design of memory peripherals circuits in 3D integrated circuits.

### Summary

It is an object of the present disclosure to provide a 3D integrated circuit that enables greater design freedom for the layout of logic circuits and that reduces routing congestion caused by memory peripheral circuits.

According to a first aspect, there is provided a three-dimensional integrated circuit, comprising a first tier, a second tier, vertically stacked above the first tier, and a memory circuit. The memory circuit comprises a bitcell array disposed in the first tier and comprising a plurality of bitcells arranged in a plurality of rows and a plurality of columns. The memory circuit also comprises a plurality of word lines disposed in the first tier, each word line connecting the bitcells of a row of the plurality of rows. Additionally, the memory circuit comprises a plurality of bit lines disposed in the first tier, each bit line connecting the bitcells of a column of the plurality of columns. A column peripheral circuit is coupled to each of the plurality of bit lines and configured to read/write data from the bitcell array during a read/write operation, the column peripheral circuit having at least an elongate first portion disposed in the second tier. The memory circuit also comprises a row decoder, coupled to each of the plurality of word lines and configured to select one of the rows of bitcells during the read/write operation, the row decoder being elongate and disposed in the second tier and extending in a direction parallel to the first portion of the column peripheral circuit.

By arranging the row decoder and the first portion of the column peripheral circuit in parallel in the second tier, additional space is created for the placement of the logic circuits in the second tier. When the row decoder and column peripheral circuits are arranged orthogonally, space in the second tier is restricted in the row direction and the column direction. By arranging them in parallel, space is only restricted in one direction. This means that larger, standard blocks of logic may be used in the second tier over the memory circuit. This enables standard blocks of logic to be placed near to each other with improved routing resources. It reduces or prevents the routing having to "jump" the blockages which could have been created in the inverted 'T' shape periphery. By aligning the row decoder and the first portion of the column peripheral circuit in parallel, routing congestion is minimised in the logic tier above the bitcell array. The row decoder and column peripheral circuit may be referred to as peripheral memory circuits. The bitcell array may be a 2D array.

The row decoder and column peripheral circuit are generally long and narrow. This is because they comprise a series of sub-circuits configured to be coupled to each word or bit line. In order to ensure efficient use of space, these sub-circuits may be arranged along the sides of the bitcell array. This gives the row decoder and column peripheral circuit an overall elongate shape. In this example, the first portion of the column peripheral circuit and the row decoder each have a length in an elongate direction greater than or equal to an extent of the bitcell array in a row or a column direction. The reduction in routing congestion achieved by placing the peripheral circuits in parallel is greater than for equivalent circuits that may be shorter in length.

The peripheral circuits may be positioned in various locations in the second tier. The peripheral circuits may be positioned in areas of the second tier which are adjacent the sides of the bitcell array. For example, the first portion of the column peripheral circuit and the row decoder may each be positioned in the second tier above an area of the first tier adjacent to a first side of the bitcell array. In this respect, the bitcell array defines a bitcell area in the horizontal plane of the first tier and the row decoder and column peripheral circuit are positioned above an area of the first tier outside of the bitcell area. This has the advantage of reducing the length of metal tracks required between the peripheral circuits and corresponding circuit elements or vias located in the first tier.

The peripheral circuits may be arranged in parallel with the word lines and orthogonally to the bit lines. In one example, the first portion of the column peripheral circuit and the row decoder are arranged in parallel with the plurality of rows. In this arrangement, the row decoder cannot be connected directly to any of the ends of the word lines. Therefore, the memory circuit further comprises a plurality of word line interconnectors, each word line interconnector may be coupled between a respective one of the plurality of word lines and the row decoder. By arranging the peripherals in this way, only one additional layer of metallisation is required to couple the row decoder to the word lines.

As an alternative, the peripheral circuits may be arranged in parallel with the plurality of columns. In this case, bit line interconnectors may be used, with each bit line interconnector coupled between a respective one of the bit lines and the column peripheral circuit.

In one example, each of the plurality of word line interconnectors is arranged in parallel with the plurality of bit lines and is aligned with one of the plurality of columns of bitcells. By aligning the word line interconnectors in this way, a conventional row decoder may be used. Because the row decoder may be coupled to the word line interconnectors in the same way it would be coupled directly to the word lines, the layout may be similar to a conventional row decoder. This reduces design costs. In one example, the row decoder may comprise a plurality of word line transistor circuits, each coupled to and aligned with a respective word line interconnector.

Memory bitcell arrays typically include one or more worst case bitcells. These are the bitcells most prone to error, typically because of their position furthest from the peripheral circuits. In order to reduce the length of metal between the row decoder and the worst case bitcells, the word line interconnectors towards the middle of the row decoder are coupled to the word lines furthest from the row decoder. The worst case bitcells are typically located in the corners of the bitcell array furthest away from the row decoder. In this example, the word line interconnectors located towards the edges of the bitcell array are coupled to word lines nearest to the row decoder, and the word line interconnectors located towards the middle of the bit array are coupled to the world lines furthest from the row decoder.

The first tier may include a plurality of metallisation layers. This enables the word line interconnects to be arranged over the word lines and other components of the bitcell array. For example, the word lines may be formed above the transistors of the bitcells. In this example, the plurality of word lines is formed in a first metallisation layer in the first tier, and the plurality of word line interconnectors are formed in a second metallisation layer in the first tier, vertically above the first metallisation layer. The three-dimensional integrated circuit may further comprise a plurality of word line vias, each configured to couple a word line to a word line interconnector and extending vertically from the first metallisation layer to the second metallisation layer.

The column peripheral circuit may be arranged in one, two or more portions. For example, the first portion in the second tier may be the only portion, including all of the column peripheral circuit components. Alternatively, the column peripheral circuit may be split between the first and second tiers. This enables the circuit elements which do not need to be coupled to a logic circuit to be arranged in the first tier. In this example, the column peripheral circuit comprises a second portion disposed in an area of the first tier adjacent a first side of the bitcell array. This area may be vertically below the first portion. The first portion of the column peripheral circuit may comprise a plurality of sense amplifiers and a plurality of write drivers, each disposed in the second tier in alignment with each respective bitcell column. The second portion of the column peripheral circuit may further comprise a column multiplexor. The two portions of the column peripheral circuit may be connected together by a plurality of vias bridging the first tier to the second tier.

The bit lines and word lines may be arranged in a variety of configurations. In one example, each of the plurality of bit lines is aligned with a respective column of bitcells, and each of the plurality of world lines is aligned with a respective row of bitcells. The plurality of bit lines and the plurality of world lines may be orthogonal to each other. The bit lines may comprise pairs of bit lines, with each pair being coupled to the same column of bitcells. One bit line of the pair is referred to as a bit line. The other bit line of the pair is referred to as a bit line bar. The bit line bar operates at the opposite polarity to the bit line.

The 3D integrated circuit includes one or more logic circuits disposed in the second tier. The logic circuits may be positioned vertically above the bitcell array. The layout of the logic circuits is conventionally restricted by the orthogonal layout of the row decoder and column peripheral circuit. Because the row decoder and column peripheral circuit are arranged in parallel, the extent of the logic circuits in either the column or row direction is unrestricted over the bitcell array. A plurality of memory circuits may be arranged in an array including rows and columns of memory circuits, with each memory circuit including an array of bitcells. The logic circuits in the second tier may be disposed such that they extend over a plurality of memory circuits, in one of the row direction or the column direction. Therefore, logic circuits having larger standard design blocks may be implemented. In addition, routing congestion in the logic circuits is reduced.

Each tier of the 3D integrated circuit includes a device layer which may be implemented in a different process technology. For example, the first tier may be optimised for RAM bitcells, whereas the second tier may be optimised for CMOS-based logic circuits. In one example, the first tier includes a first device layer and a first back end of line (BEOL) layer, stacked above the first device layer. The second tier may include a second device layer and a second BEOL layer, stacked above the second device layer. The bitcell array may be formed in the first device layer, and the row decoder is formed in the second device layer.

The tiers of the 3D integrated circuit may be fabricated using any suitable 3D integration technique. For example, the first tier and the second tier may be sequentially integrated or bonded. The type of bonding may be hybrid bonding, or other suitable bonding techniques.

The memory circuit may be configured in a butterfly arrangement. This includes two bitcell arrays being arranged next to each other in the first tier. The two bitcells arrays may then share elements of the row decoder or column peripheral circuit. In this example, the 3D integrated circuit may include a plurality of said memory circuits, the memory circuits being arranged in pairs, each pair being arranged in a butterfly configuration.

The memory circuit may be random-access memory (RAM). Alternatively, the circuits described above may be implemented with any memory which utilises a bitcell array and row and column peripheral circuits. Memory which utilises an 'L', inverted 'T', or butterfly peripheral configuration may benefit from the parallel alignment of the row and column peripheral circuits. For example, the memory may be static RAM (SRAM), dynamic RAM (DRAM) or read-only memory (ROM). It will be clear that for ROM memories there is no write operation. Hence, the read/write operation mentioned in the claims should be read as a read operation and also a write operation if the memory circuit used can be written to. In case of a ROM memory circuit the read/write operation of the claims should be read as a read operation only.

According to a second aspect, there is provided an integrated memory and logic device, comprising a plurality of the three-dimensional integrated circuits of any of the above clauses, arranged in a plurality of rows and a plurality of columns. The row decoders and the column peripheral circuits of said plurality of three-dimensional integrated circuits are arranged in parallel in a plurality of rows.

According to a third aspect, there is provided a three-dimensional integrated circuit, comprising: a first tier; a second tier, vertically stacked above the first tier; and a memory circuit, comprising: a bitcell array comprising a plurality of bitcells arranged in a plurality of rows and a plurality of columns and disposed within the first tier; a plurality of word lines, extending along each row, and coupled to each bitcell in a respective row; and a row decoder, disposed in the second tier, and arranged in parallel with the word lines.

According to a fourth aspect, there is provided a three-dimensional integrated circuit, comprising: a first tier; a second tier, vertically stacked above the first tier; and a memory circuit, comprising: a bitcell array disposed within the first tier; and at least two elongate peripheral circuits, arranged in parallel with each other and disposed in the second tier; and a logic circuit, disposed in the second tier.

It should be noted that relative spatial terms such as "vertical", "above", "below", "stacked" are to be understood as denoting locations or directions in relation to a normal direction of a substrate, or in relation to a bottom-up direction of the device layer stack. Correspondingly, terms such as "lateral" and "horizontal" are to be understood as locations or directions parallel to the substrate, i.e., parallel to an upper surface or the main plane of extension of the substrate.

Further features and advantages of the invention will become apparent from the following description of preferred embodiments of the invention, given by way of example only, which is made with reference to the accompanying drawings.

### Brief Description of the Drawings

The above, as well as additional objects, features, and advantages, may be better understood through the following illustrative and non-limiting detailed description, with reference to the appended drawings. In the drawings, like reference numerals will be used for like elements unless stated otherwise.
Figure 1 shows a plan view of a conventional 2D RAM circuit;
Figure 2 shows a plan view of a conventional 2D RAM circuit having a butterfly configuration;
Figure 3A shows a side view of a 3D integrated circuit;
Figure 3B shows a perspective view of the 3D integrated circuit of Figure 3A;
Figure 4 shows a plan view of a simulation of the 3D integrated circuit of Figure 3A;
Figure 5 shows a plan view of a 3D integrated circuit in accordance with an embodiment of the disclosure;
Figure 6 shows a side view of the 3D integrated circuit of Figure 5;
Figure 7 shows a perspective view of the 3D integrated circuit of Figure 5; and
Figures 8A to 8D show various plan views of a 3D integrated circuit including a group of four 3D memory circuits.

### Detailed Description

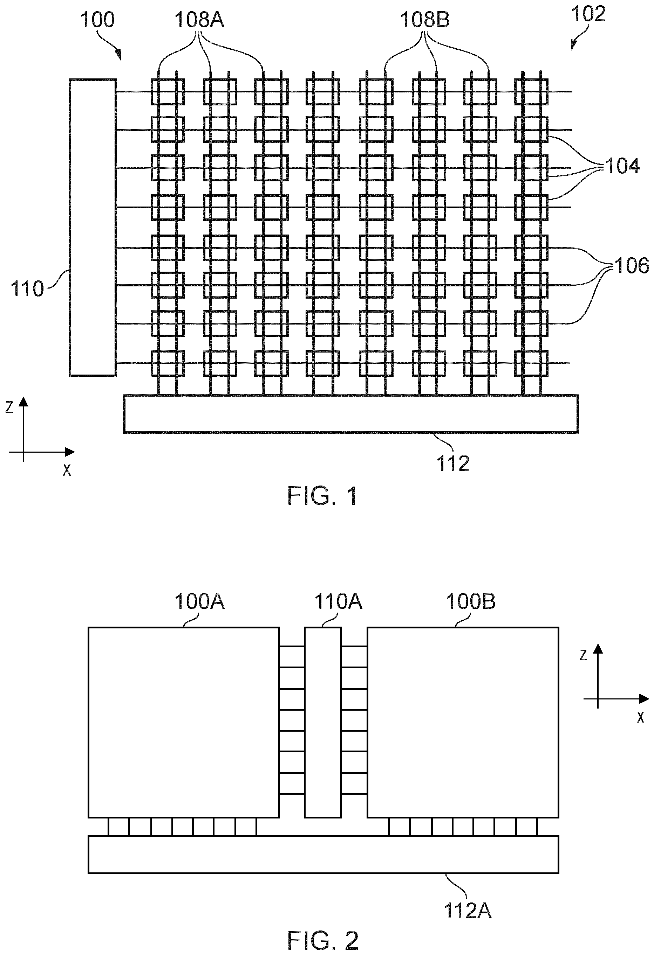

Figure 1 shows a schematic plan view of a conventional 2D RAM circuit 100. RAM circuit 100 includes a bitcell array 102 which includes a plurality of bitcells 104. The bitcells 104 are arranged in a series of rows and columns. In this example, the number of rows is the same as the number of columns. While it is conventional for the number of rows and columns to be the same, they may be different in some circumstances. The RAM circuit 100 also includes a plurality of word lines 106. Each word line 106 is coupled to all of the bitcells 104 in a given row. In Figure 1, the word lines 106 are arranged in parallel with the rows, which is the conventional orientation of word lines. The RAM circuit 100 also includes a plurality of bit lines 108A and bit line bars 108B. Each bit line 108A and each bit line bar 108B is coupled to all of the bitcells 104 in a given column. The bit lines 108A and the bit line bars 108B are arranged in pairs, with each pair being coupled to a column of bitcells 104. The bit line bars 108B operate at the opposite polarity to the bit lines 108A. The bit lines 108A and bit line bars 108B are arranged in parallel with the columns.

The RAM circuit 100 also includes a row decoder 110, which is disposed along a side of and adjacent to the bitcell array 102, and in parallel with the columns. Each of the word lines 104 is connected to the row decoder 110. The row decoder 110 is configured to select a row for memory read/write operations. In this respect, the row decoder 110 represents a series of sub-circuits, each of which is coupled to one of the word lines 104. The row decoder 110 has overall dimensions such that it is elongate in shape. This shape represents the overall footprint of the circuits which make up the row decoder.

The RAM circuit 100 also includes a column peripheral circuit 112, which is disposed along a side of the bitcell array 102 in parallel with the rows. Each of the bit lines 108A and bit line bars 108B is connected to the column peripheral circuit 112. The column peripheral circuit 112 may include a number of different sub-circuits performing different functions, such as a multiplexor, sense amplifiers and write drivers. Each pair of bit lines 108A and bit line bars 108B is coupled one or more circuits configured to operate a respective column of bitcells 104. The column peripheral circuit 112 has overall dimensions such that it is elongate in shape. This shape represents the overall footprint of the circuits which make up the column peripheral circuit.

One of the reasons for the row decoder 110 and the column peripheral circuit 112 being elongate and arranged adj acent to the sides of the bitcell array 102 is to ensure that the RAM circuit is as compact as possible. Because the row decoder 110 and the column peripheral circuit 112 are arranged in the same tier as the bitcell array 102, they must be arranged outside of the perimeter of the bitcell array. By arranging them adjacent to and along the sides of the bitcell array 102, the opportunity to maximise the number of bitcell arrays on a given substrate is increased.

The orthogonal arrangement of the row decoder 110 and column peripheral circuit 112 may referred to as an 'L' shaped configuration.

The 2D RAM circuit 100 is shown in plan view in Figure 1. As shown in Figure 1, the column direction is indicated as the 'z' direction, and the row direction is indicated as the `x' direction. This represents a horizontal plane, with the rows and columns of the bitcell array being formed in the z-x horizontal plane.

Figure 2 shows a schematic plan view of a pair of conventional 2D RAM circuits formed in a butterfly arrangement. 2D RAM circuits 100A and 100B are fabricated adjacent to each other, with the circuits being aligned in the row or `x' direction. A row decoder 110A is formed between the 2D RAM circuits 100A and 100B, with these circuits sharing the row decoder 110A. A column peripheral circuit 112A is formed along a side of the 2D RAM circuits 100A and 100B providing both circuits with the data reading and writing functions performed by column peripheral circuit 112A.

This arrangement is referred to as a butterfly arrangement because of the symmetry around the shared row decoder 110A. This arrangement may also be referred to as an inverted 'T' configuration.

A butterfly arrangement may be used to reduce word line load, decrease delays, improve performance and efficiently use space on the chip.

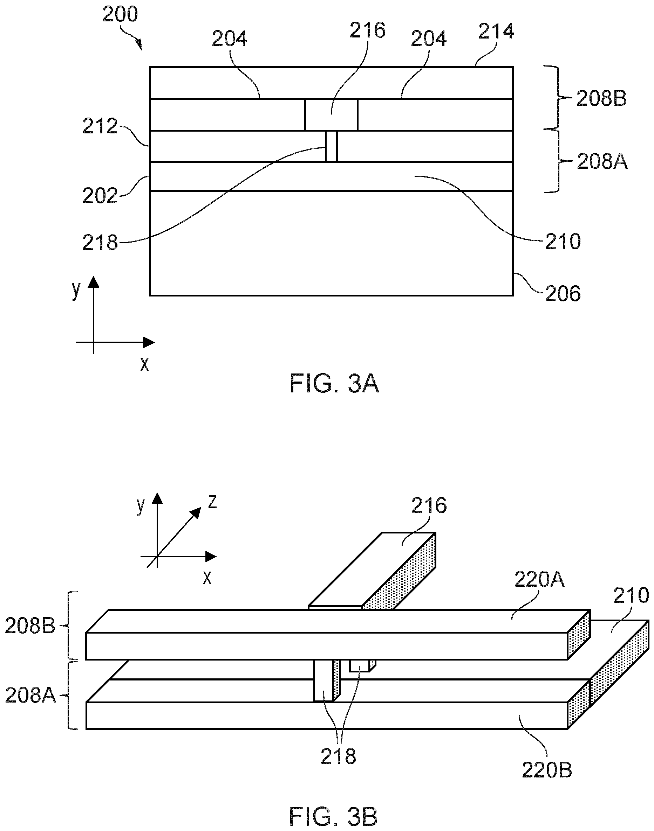

Figure 3A is a side-view of a 3D integrated circuit 200 that includes a memory circuit 202 and a logic circuit 204. The 3D integrated circuit 200 includes a substrate 206 above which the memory and logic circuits are fabricated. The memory circuit 202 may be similar, in terms of its constituent parts, to the 2D RAM circuit 100.

The 3D integrated circuit 200 is arranged in two tiers. A first tier 208A is formed on and above the substrate 206. A second tier 208B is formed on and above the first tier 208B. Each tier represents a particular process technology which is configured to support either memory bitcells or logic transistors. Each tier may itself include a number of layers, such as a transistor layer and a back-end of line (BEOL) layer, which may include multiple layers of metallisation.

A bitcell array 210 of the memory circuit 202 is formed in the first tier 208A. The logic circuit 204 is formed in the second tier 208B. The first tier 208A also includes a first tier BEOL layer 212 which is arranged over the bitcell array 210. The second tier 208B includes a second tier BEOL layer 214 which is arranged over the logic circuit 204.

A row decoder 216 of the memory circuit 202 is formed in the second tier 208B. In this example, the row decoder 216 is formed between two parts of the logic circuit 204. One or more vias 218 couple the bitcell array 210 to the row decoder 216. The column peripheral circuit of memory circuit 204 is not shown in Figure 3A but will be shown and described below in connection with Figure 3B.

Figure 3B is a perspective view of the 3D integrated circuit 200 shown in Figure 3A. Various components are omitted for clarity. In particular, the BEOL layers 212, 214 and the logic circuit 204 are not shown. The bitcell array 210 of memory circuit 202 is shown in the first tier 208A. Figure 3B also shows a column peripheral circuit of the memory circuit 202. A first portion 220A of the column peripheral circuit is disposed in the second tier 208B of the 3D integrated circuit 200. A second portion 220B is disposed in the first tier 208A.

The first portion 220A of the column peripheral circuit may include the sense amplifiers and the write drivers. The second portion 220B of the column peripheral circuit may include the column select/multiplexor circuitry.

As can be seen, because of the placement of the row decoder 216 and the first portion 220A of the column peripheral circuit in the second tier 208B, the design of the layout of the logic circuit 204 is restricted. The logic circuit 204 may not be freely designed to occupy all of the area provided in the second tier 208B. Parts of the logic circuit 204 positioned either side of the row decoder 216 must be connected by routing around the row decoder 216.

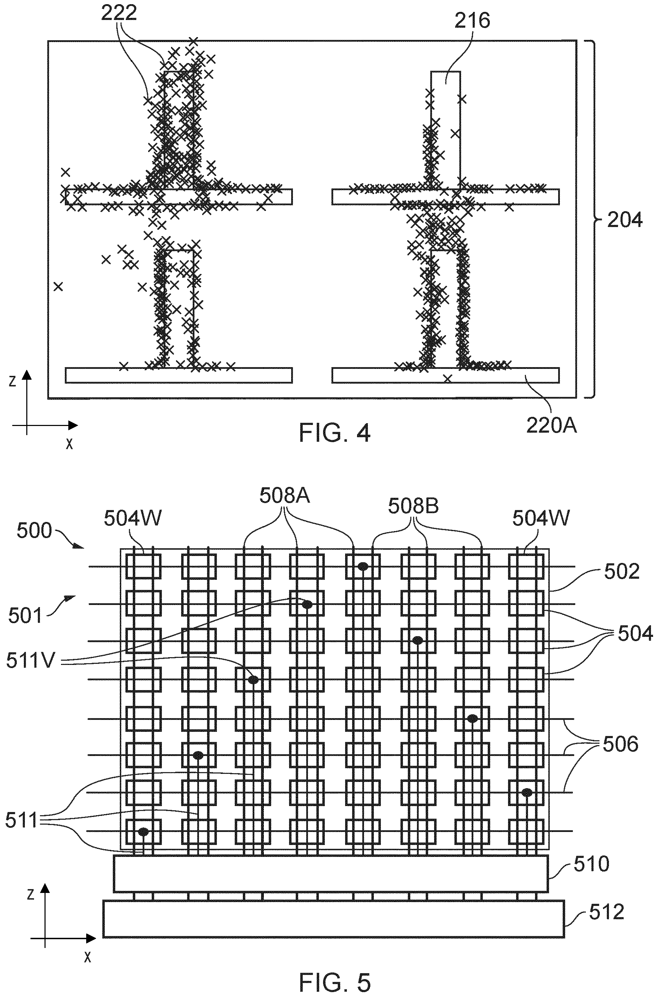

Figure 4 shows a plan view of a simulation of the 3D integrated circuit 200. The view shows the 'top' of the second tier 208B, but with the BEOL layer 214 removed. Therefore, Figure 4 shows the top of the logic circuit 204, the row decoder 216, and the first portion 220A of the column peripheral circuit. The butterfly or inverted 'T' shapes are the row decoders 216 and first portions 220A of the column peripheral circuits of the memory circuit 202. The area between the inverted 'T' shapes represents the logic circuit 204. In this example, a group of four butterfly arrangements are shown. In practice, the total number of circuits may be much greater. In use, because signals in the logic circuit 204 must be routed around the row decoders and column peripheral circuits, congestion occurs along the edges of the inverted 'T' shapes. This congestion is worst in the corners of the inverted 'T' shapes. The congestion is represented by the `x' marks 222 which represents a routing violation. They are a result of the simulation or a calculation to determine a possible routing solution.

Figure 5 is schematic plan view of a 3D integrated circuit 500 in accordance with an embodiment of the disclosure. The 3D integrated circuit 500 includes a memory circuit, for example a 3D RAM circuit 501. As previously stated the memory circuit may be any memory type (RAM, MRAM, DRAM, RRAM, ROM, PROM,...) which utilises a bitcell array and row decoder and column peripheral circuits in accordance with the claims. Even if the figures are described below in the RAM context, the skilled person will understand that other types of memories are included in the scope description and the scope of the claims. Figure 5 only shows components of the exemplary 3D RAM memory circuit 501 for clarity. In practice, these components are incorporated with a logic circuit, as will be described below.

The 3D RAM circuit 501 includes a bitcell array 502 which includes a plurality of bitcells 504. The bitcells 504 are arranged in a series of rows and columns. In this example, the number of rows is the same as the number of columns, however they may be different in some circumstances. The 3D RAM circuit 501 also includes a plurality of word lines 506. Each word line 506 is coupled to all of the bitcells 504 in a given row. In Figure 5, the word lines 506 are in parallel with the rows of bitcells 504. The 3D RAM circuit 501 also includes a plurality of bit lines 508A and bit line bars 508B. Each bit line 508A and each bit line bar 508B is coupled to all of the bitcells 504 in a given column. The bit lines 508A and the bit line bars 508B are arranged in pairs, with each pair being coupled to a column of bitcells 504. The bit line bars 508B operate at the opposite polarity to the bit lines 508A. The bit lines 508A and bit line bars 508B are arranged in parallel with the columns of bitcells 504.

The 3D RAM circuit 501 also includes a row decoder 510. The row decoder 510 is disposed adjacent to the bitcell array 502 and along a side of the bitcell array 502. The row decoder 510 is arranged in parallel with the rows of bitcells 504 and the word lines 506, and orthogonal to the columns of bitcells 504 and the bit lines 508A and the bit line bars 508B. Because the row decoder 510 is disposed in parallel with the rows of bitcells 504, the word lines 504 cannot be directly connected to the row decoder 510. Therefore, the 3D RAM circuit 501 also includes a plurality of word line interconnectors 511. The word line interconnectors 511 are arranged in parallel with the columns of bitcells 504. Each word line interconnector 511 is aligned with a column of bitcells 504 and is coupled to one of the available word lines 506 using vias 511V. Each word line interconnector 511 is coupled to a different respective word line 506.

The word line interconnectors 511 located towards the edge of the bitcell array 502 are connected to the word lines 506 closest to the row decoder 510. The word line interconnectors towards the middle of the bitcell array 502 are connected to the word lines 506 furthest from the row decoder 510. The benefit of this arrangement is that the length of metal required to reach the worst case bitcells is reduced. In Figure 5, the worst-case bitcells 504W are in the top left and top right corners. By placing the word line interconnector 511 in the middle of this row, the overall length of metal required to reach the worst-case bitcells 504W is minimised.

The row decoder 510 is configured to select a row for memory read/write operations. In this respect, the row decoder 510 represents a series of circuits, each of which is coupled to one of the word lines 504 and word line interconnectors 511. The row decoder 510 has overall dimensions such that it is elongate in shape. This shape represents the overall footprint of the circuits which make up the row decoder 510.

The 3D RAM circuit 501 also includes a column peripheral circuit 512, which is disposed spaced from the bit cell array and along the same side of the bitcell array 502 as the row decoder 510. Each of the bit lines 508A and bit line bars 508B is connected to the column peripheral circuit 512. The column peripheral circuit 512 may include a number of different sub-circuits performing different functions, such as a multiplexor, sense amplifiers and write drivers. Each pair of bit lines 508A and bit line bars 508B is coupled one or more circuits configured to operate the respective column of bitcells 504. The column peripheral circuit 512 has overall dimensions such that it is elongate in shape. This shape represents the overall footprint of the circuits which make up the column peripheral circuit.

Because the row decoder 510 and column peripheral circuit 512 are located on the same side of the bitcell array 502, they are arranged in parallel with each other. This is in contrast with the conventional 2D RAM circuit 100 shown in Figure 1, where they are orthogonally arranged. It will be clear that with respect to Figure 5 the location of the row decoder 510 and column peripheral circuit 512 can be interchanged or even interleaved, these embodiments fall within the scope of the disclosure.

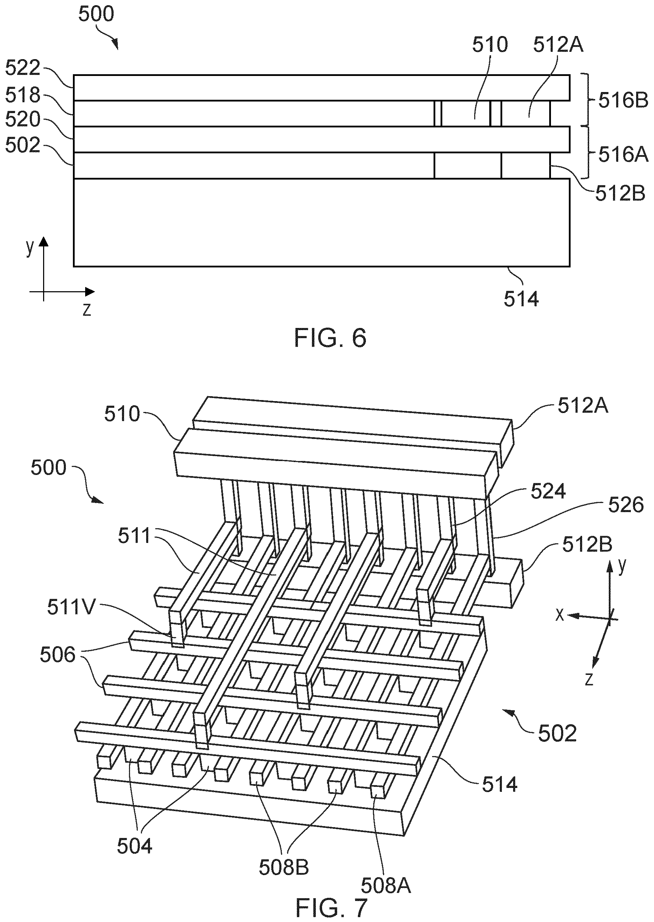

Some of the components of the 3D RAM circuit 501 are located in different tiers of the 3D integrated circuit 500. These tiers are not shown in Figure 5, but will be described in more detail below with reference to Figure 6.

Figure 6 is a side or cross-sectional view of the 3D integrated circuit 500. The side view is through the y-z plane, with the z-direction being aligned with the direction of the columns.

The 3D integrated circuit 500 includes a substrate 514, over which the 3D RAM circuit 501 is fabricated. The 3D integrated circuit 500 is arranged in two tiers. A first tier 516A is formed on and above the substrate 514. A second tier 516B is formed on and above the first tier 516B. Each tier represents a particular process technology which is configured to support, for example, either memory bitcells or logic transistors. Each tier may itself include a number of layers, such as a transistor layer and a back-end of line (BEOL) layer, which may include multiple layers of metallisation. These layers are typically part of a layered planar technology implementation for integrated electronic circuits.

The bitcell array 502 of the exemplary 3D RAM circuit 501 is formed in the first tier 516A. A logic circuit 518 is formed in the second tier 516B. The first tier 516A also includes a first tier BEOL layer 520 which is arranged over the bitcell array 502. The second tier 516B includes a second tier BEOL layer 522 which is arranged over the logic circuit 518. The logic circuit 518 may include logic transistors, digital macro cells and routing interconnects. The logic circuit 518 may be formed from a CMOS-based process technology.

The row decoder 510 is also formed in the second tier 516B. The row decoder 510 includes active cells (transistors) for performing the functions of the row decoder. The column peripheral circuit 512 includes a first portion 512A which is disposed in the second tier 516B of the 3D integrated circuit 500. A second portion 512B of the column peripheral circuit 512 is disposed in the first tier 516A. The first portion 512A of the column peripheral circuit may include the sense amplifiers and the write drivers. The second portion 512B of the column peripheral circuit may include the column select/multiplexor circuitry.

The row decoder 510 and column peripheral circuitry 512 are coupled to the bitcells 504 by various metal layers and vias formed in the first tier BEOL layer 520. The metal layers and vias are not shown in Figure 6 but will be shown and described in connection with Figure 7.

Figure 7 is a perspective view of the 3D integrated circuit 500 shown in Figures 5 and 6. For clarity, Figure 7 does not show the logic circuit 518 or the various layers of insulation that are present between the metal tracks, vias and tiers. Figure 7 shows further details of the arrangement of the metal tracks and vias that connect the bitcells 504, the row decoder 510, the first portion 512A and second portion 512B of the column peripheral circuits.

In Figure 7 the bit lines 508A and bit line bars 508B are formed in an intermediate layer of metallisation which is formed in the same layer as the bitcells 504. The word lines 506 are formed in a first metal layer M1 of the first tier BEOL layer 520. The world line interconnectors 511 are formed in a second metal layer M2 of the first tier BEOL layer 520. Vias 511V are formed at the crossing of the word line interconnectors 511 in layer M2 and the word lines 506 in layer M1, typically as shown in Figure 7 between the ends of the word lines interconnectors 511 in layer M2 and the word lines 506 in layer M1. The world line interconnectors 511 are coupled with the row decoder 510 by vias 524. The first portion 512A and second portion 512B of the column peripheral circuit 512 are coupled to each other and the bit lines by vias 526.

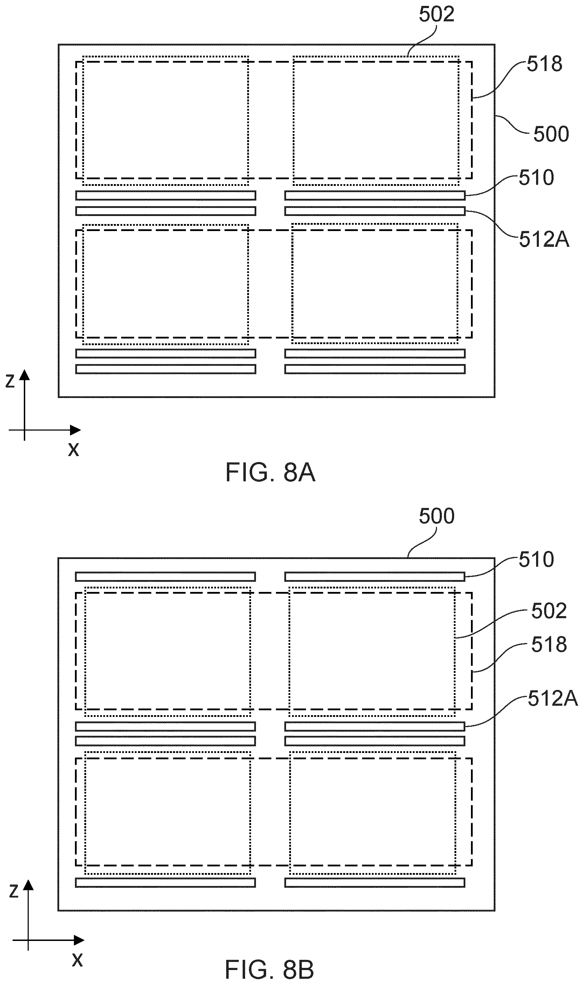

Figure 8A shows a plan view of the 3D integrated circuit 500. The circuit shows a group of four 3D memory circuits, hereunder described as 3D RAM circuits, including the 3D RAM circuit 501. The view shows the 'top' of the second tier 516B, but with the second tier BEOL layer 522 removed. Therefore, Figure 8A shows the top of the logic circuit 518, the row decoder 510, and the first portion 512A of the column peripheral circuit. The bitcell array 502 is below the top surface of the second tier 516B and is therefore shown by a broken line.

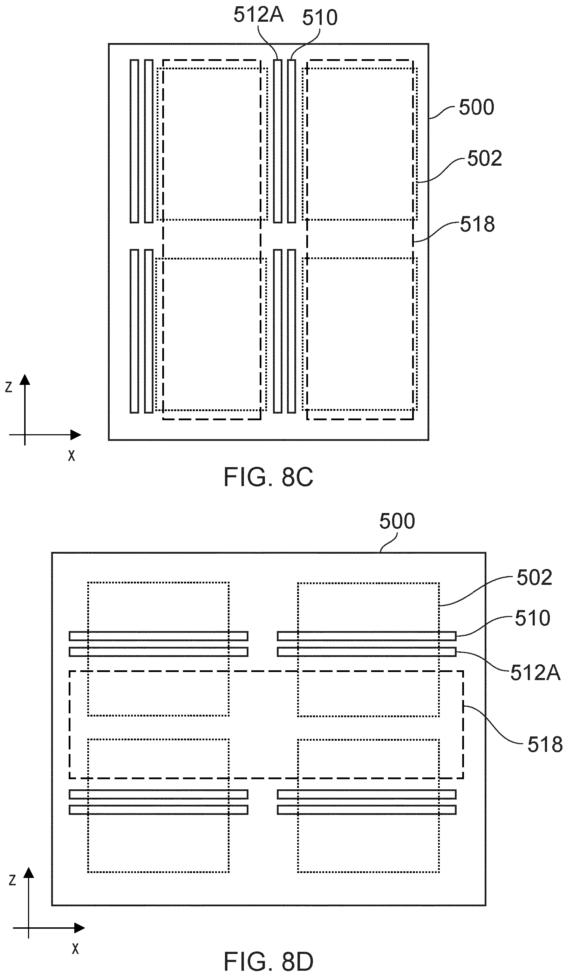

As a result of the parallel configuration of the row decoder 510 and the first portion 512A of the column peripheral circuit, the inverted 'T' shape shown in Figure 4 is no longer present in second tier 516B. As such, the logic circuit 518 may be designed to extend freely in the row direction. This enables larger standard units (or macros) of logic circuitry to be used. Because the logic circuit 518 does not need to be routed around the column-oriented row decoder 510 the amount of congestion suffered by the circuit is significantly reduced. In Figure 8A, the logic circuit 518 extends over two bitcell arrays 502 in the "x" direction. In devices which include a larger number of bitcells in the "x" direction, the logic circuit 518 may extend in the "x" direction over all the bitcell arrays 502 that are present. The logic circuit 518 need not have a length in the "x" direction which is a whole number multiple of the number of bitcell arrays 502. Instead, the logic circuit 518 may partially overlap one or more of the bitcell arrays 502. Additionally, the logic circuit 518 need not extend fully over two bitcell arrays 502. Instead, the logic circuit 518 may only extend into the area previously occupied by the "z" oriented row decoder, thereby having a length in the "x" direction only marginally greater than a single bitcell array 502. The same principle applies in Figures 8B, 8C and 8D, which will be described below.

Figure 8B shows an alternative arrangement for the 3D integrated circuit 500, in which the row decoder 510 and the first portion 512A of the column peripheral circuit are disposed on opposing sides of the bitcell array 502. This arrangement achieves the same benefit in terms of logic circuit design freedom as the arrangement shown in Figure 8A.

Figure 8C shows an alternative arrangement for the 3D integrated circuit 500, in which the row decoder 510 and the first portion 512A of the column peripheral circuit are aligned with the columns, rather than the rows, and placed along one side of the bitcell array 502. In this arrangement, the row decoder may be coupled directly to the word lines 506, and hence no world line interconnectors are required. However, the bit lines 508A and bit line bars 508B would require row-oriented bit line interconnectors. As there are twice as many bit lines as word lines, this is a less efficient layout. However, the logic circuit design freedom is equal to that of the above examples, albeit in the column direction. This may be advantageous for certain circuit designs.

Figure 8D shows an alternative arrangement for the 3D integrated circuit 500, in which the row decoder 510 and the first portion 512A of the column peripheral circuit are disposed towards the centre of the bitcell array 502. In this example they are disposed in a row-orientation. However, a similar column orientation could be implemented. Because the row decoder and first portion 512A of the column peripheral circuit are in the second tier 516B, they are not restricted to being at the edge of the bitcell array 502. Therefore, they may be placed overlapping the bitcell array 502. By placing the row decoder 510 and the first portion 512A of the column peripheral circuit close to each other, the space provided for, and the design freedom given to the logic circuit 518 is similar to the arrangement shown in Figure 8A.

In the example shown in Figures 7 and 8A, the first portion 512A and the second portion 512B of the column peripheral circuit have the same or similar dimensions, and are aligned in the vertical direction. In this respect, the first portion 512A is positioned vertically above the second portion 512B. This arrangement provides for straight-forward via connections to be made between the first portion 512A and the second portion 512B. However, while the second portion 512B should be disposed outside of the bitcell array 502, because they are both in the first tier 516A, the first portion 512A may be positioned differently. For example, as shown in Figure 8D, the first portion 512A may be positioned vertically above the bitcell array 502. In this example, appropriate metal tracks would need to be formed (not shown) between the first portion 512A and the second portion 512B of the column peripheral circuit.

In the above-described examples, the row decoder 510 has been shown as a single unit formed in the second tier 516B, and the column peripheral circuit has been shown as a two-part circuit, formed in both the first tier 516A and the second tier 516B. The column peripheral circuit 512 may be designed as a single unit disposed completely within the second tier 516B, in a similar manner to the row decoder 510. Furthermore, the row decoder 510 may be divided into two parts, with one part being in the first tier 516A and one part being in the second tier 516B. For both circuits, any parts formed in the first tier 516A should be positioned outside of the bitcell array 502. Any parts formed in the second tier 516B may be aligned in parallel and positioned adjacent each other, to maximise the design freedom with respect to the logic circuits.

In the embodiment in which all of the column peripheral circuit 512 is positioned in the second tier, the row decoder 510 and the column peripheral circuit 512 may be disposed in an area of the second tier above and aligned with the bitcell array 502. In this example, appropriate routing may be provided via the first tier BEOL layer 520 to couple the word line interconnectors 511, the bit lines 508A and the bit line bars 508B to the peripheral circuits. As with the prior embodiments, in this example the row decoder 510 and the column peripheral circuit 512 may be aligned in parallel, in order to maximise the space available in the second tier for the logic circuit 518.

The row decoder 510 and column peripheral circuit 512 are typically elongate in shape. That is, their extent in the elongate direction is greater than their width or depth. Because both circuits need to be coupled to all bitcells 504, the row decoder 510 and column peripheral circuit 512 generally extend to at least the width of the bitcell array 502. In this respect, they may have the same or similar extent in the elongate direction. In the example shown in Figure 5, the extent in the elongate direction is the extent in the row direction. The row decoder 510 and the first portion 512A of the column peripheral circuit are arranged adjacent to each other in the example shown in Figure 5. In this respect, because the row decoder 510 and the first portion 512A of the column peripheral circuit represent a collection of circuit components. The row decoder 510 and first portion 512A may be directly adjacent to each other, or may be slightly separated, but no other components or circuits are formed between them. They may be positioned as close as it possible without affecting the functionality of the circuits.

The position of the row decoder 510 and the first portion 512A of the column peripheral circuit 512 in the second tier 516B is not restricted by the bitcell array 502. However, in the examples shown in Figures 8A, 8B and 8C, the row decoder 510 and the first portion 512A of the column peripheral circuit are positioned to one side of the bitcell array 502 in order to allow the shortest path to corresponding elements in the first tier 516A. In these examples, the row decoder 510 and the first portion 512A of the column peripheral circuit are located in an area of the second tier 516B that is vertically above an area of the first tier 516A that is adjacent to and extends along a side of the bitcell array 502.

In the above examples, the vertical direction is defined as the y-direction. The tiers are stacked in the vertical direction. The horizontal plane is defined as the x-z plane. The bitcell array 502 and logic circuit 518 extend in the horizontal plane. Where the description or claims refer to a component or layer being 'above' another component or layer, this only refers to the relative orientation shown in the Figures. In use, the device may be oriented differently, and for example may be inverted. In this respect, the relative positioning of the components is described in the context of the conventional arrangement shown in the Figures. For example, in the context of the tiers, each tier has a main surface and a certain thickness. The second tier 516B is stacked on the main surface of the first tier 516A.

In the above-described examples, the term 2D is used to described circuits that do not extend into multiple tiers. In this respect, 2D circuits do have a depth (i.e. technically a third dimension), however the circuit components are generally laid out in the same plane.

The first tier 516A and second tier 516B may be fabricated using sequential integration, in which the second tier is fabricated sequentially above the first tier. Alternatively, the first tier 516A and the second tier 516B may be fabricated separately and coupled together using a bonding technique such as hybrid bonding.

The above embodiments are to be understood as illustrative examples of the invention. Further embodiments of the invention are envisaged. It is to be understood that any feature described in relation to any one embodiment may be used alone, or in combination with other features described, and may also be used in combination with one or more features of any other of the embodiments, or any combination of any other of the embodiments. Furthermore, equivalents and modifications not described above may also be employed without departing from the scope of the invention, which is defined in the accompanying claims.

## Claims

1. A three-dimensional integrated circuit, comprising:
a first tier;
a second tier, vertically stacked above the first tier; and
a memory circuit, comprising:
a bitcell array disposed in the first tier and comprising a plurality of bitcells arranged in a plurality of rows and a plurality of columns;
a plurality of word lines disposed in the first tier, each word line connecting the bitcells of a row of the plurality of rows;
a plurality of bit lines disposed in the first tier, each bit line connecting the bitcells of a column of the plurality of columns;
a column peripheral circuit, coupled to each of the plurality of bit lines and configured to read/write data from the bitcell array during a read/write operation, the column peripheral circuit having at least an elongate first portion disposed in the second tier; and
a row decoder, coupled to each of the plurality of word lines and configured to select one of the rows of bitcells during the read/write operation, the row decoder being elongate and disposed in the second tier and extending in a direction parallel to the first portion of the column peripheral circuit.

2. A three-dimensional integrated circuit according to claim 1, wherein the first portion of the column peripheral circuit and the row decoder each have a length in an elongate direction greater than or equal to an extent of the bitcell array in a row or a column direction.

3. A three-dimensional integrated circuit according to claims 1 or 2, wherein the first portion of the column peripheral circuit and the row decoder are each positioned in the second tier above an area of the first tier adjacent to the bitcell array on a first side of the bitcell array.

4. A three-dimensional integrated circuit according to any of claims 1 to 3, wherein the first portion of the column peripheral circuit and the row decoder are arranged in parallel with the plurality of rows; and the memory circuit further comprises a plurality of word line interconnectors, each word line interconnector coupled between a respective one of the plurality of word lines and the row decoder.

5. A three-dimensional integrated circuit according to claim 4, wherein:
each of the plurality of word line interconnectors is arranged in parallel with the plurality of bit lines and is aligned with one of the plurality of columns of bitcells; and
the row decoder comprises a plurality of word line transistor circuits, each coupled to and aligned with a respective word line interconnector.

6. A three-dimensional integrated circuit according to claim 5, wherein the word line interconnectors located towards the edges of the bitcell array are coupled to word lines nearest to the row decoder, and the word line interconnectors located towards the middle of the bit array are coupled to the world lines furthest from the row decoder.

7. A three-dimensional integrated circuit according to any preceding claim, wherein the plurality of word lines is formed in a first metallisation layer in the first tier, and the plurality of word line interconnectors are formed in a second metallisation layer in the first tier, vertically above the first metallisation layer; the three-dimensional integrated circuit further comprising a plurality of word line vias, each configured to couple a word line to a word line interconnector, and extending vertically from the first metallisation layer to the second metallisation layer.

8. A three-dimensional integrated circuit according to any preceding claim, wherein the column peripheral circuit comprises a second portion disposed in an area of the first tier adjacent a first side of the bitcell array, and wherein the first portion of the column peripheral circuit comprises a plurality of sense amplifiers and a plurality of write drivers, each disposed in the second tier in alignment with each respective bitcell column, and the second portion of the column peripheral circuit further comprises a column multiplexor.

9. A three-dimensional integrated circuit according to any preceding claim, wherein each of the plurality of bit lines is aligned with a respective column of bitcells, and each of the plurality of world lines is aligned with a respective row of bitcells, the plurality of bit lines and the plurality of world lines being orthogonal to each other.

10. A three-dimensional integrated circuit according to any preceding claim, further comprising one or more core logic circuits, disposed in the second tier.

11. A three-dimension integrated circuit according to any preceding, wherein:
the first tier includes a first device layer and a first back end of line (BEOL) layer, stacked above the first device layer;
the second tier includes a second device layer and a second BEOL layer, stacked above the second device layer; and
the bitcell array is formed in the first device layer, and the row decoder is formed in the second device layer.

12. A three-dimensional integrated circuit according to any preceding claim, wherein the first tier and the second tier may be sequentially integrated or bonded.

13. A three-dimensional integrated circuit according to any preceding claim, further comprising a plurality of said memory circuits, the memory circuits being arranged in pairs, each pair being arranged in a butterfly configuration.

14. A three-dimensional integrated circuit according to any preceding claim, wherein the memory circuit is a random-access memory circuit (RAM).

15. An integrated memory and logic device, comprising:
a plurality of the three-dimensional integrated circuits of any of claims 1 to 14, arranged in a plurality of rows and a plurality of columns; wherein
the row decoders and the column peripheral circuits of said plurality of three-dimensional integrated circuits are arranged in parallel in a plurality of rows.
